Europäisches Patentamt

European Patent Office

Office européen des brevets

(11) Numéro de publication: **0 251 908 B1**

## (12) FASCICULE DE BREVET EUROPEEN

(45) Date de publication de fascicule du brevet:
30.10.91

(51) Int. Cl.⁵: **H03B 23/00**

(21) Numéro de dépôt: 87401473.1

(22) Date de dépôt: 25.06.87

(54) Dispositif générateur de signaux à fréquence variable programmable.

(30) Priorité: 25.06.86 FR 8609193

(43) Date de publication de la demande:
07.01.88 Bulletin 88/01

(45) Mention de la délivrance du brevet:
30.10.91 Bulletin 91/44

(84) Etats contractants désignés:
DE FR GB IT NL SE

(56) Documents cités:
EP-A- 0 088 669
US-A- 3 548 320

PATENT ABSTRACTS OF JAPAN, vol. 3, no.
107 (E-136), 8 septembre 1979, page 97 E 36;
& JP-A-54 85 091 (HITACHI SEISAKUSHO
K.K.) 07-06-1979

ELECTRONICS LETTERS, vol. 18, no. 23, 11
novembre 1982, pages 1017- 1019, Londres,
GB; J.J. HILL et al.: "Digital method of sweep
frequency generation"

SOVIET INVENTIONS ILLUSTRATED, Section
R, semaine B05, résumé no. B0075B/05, 14
mars 1979, Derwent Publications Ltd., GB; &

SU-A-59 69 54 (ASEL) 25-02-1978

(73) Titulaire: SOCIETE DE FABRICATION D'INS-
TRUMENTS DE MESURE (S.F.I.M.)
13, avenue Marcel Ramolfo-Garnier
F-91301 Massy(FR)

(72) Inventeur: Pelletier, Charlie
67, rue Jean Jaurès
F-91300 Massy(FR)

(74) Mandataire: Martin, Jean-Jacques et al
Cabinet REGIMBEAU 26, Avenue Kléber
F-75116 Paris(FR)

EP 0 251 908 B1

## Description

L'invention est relative à un dispositif générateur de signaux à fréquence variable programmable, la loi de variation de la fréquence étant une loi polynomiale du temps.

Les générateurs de signaux à fréquence variable programmables ont jusqu'à ce jour fait l'objet de nombreux travaux.

L'une des solutions retenues en raison de son caractère immédiat consiste à partir d'un générateur de signaux de fréquence donnée à utiliser un diviseur de fréquence programmable, ce diviseur pouvant directement être commandé par un séquenceur ou un calculateur. Ce type de solution, s'il permet effectivement d'obtenir des lois de variation de fréquence correspondant à celles préétablies par le programme, présentent cependant l'inconvénient inhérent aux systèmes pilotés par logiciel, lesquels, le plus souvent, ne permettent pas un traitement en temps réel, les temps de calcul des programmes, en fonction des applications souhaitées, pouvant devenir trop importants pour l'obtention d'une réponse du système et d'une variation correspondante de fréquence en temps réel. En outre, le caractère éminemment discret du nombre de valeurs des rapports de division susceptibles d'être mis en oeuvre au niveau du diviseur programmable utilisé ne permet d'établir que certaines lois déterminées de variation de fréquence, lois correspondant à des variations discrètes de fréquence, toute variation continue entre valeurs discrètes précitées étant exclue avec pour conséquence une absence correspondante de variation continue entre valeurs élémentaires de fréquence constituant une loi programmée.

Par ailleurs, on connaît de la demande de brevet européen EP-A-0 088 669, un dispositif générateur de signaux à fréquence variable programmable selon une loi de variation polynomiale du temps, comprenant :
- un oscillateur de référence permettant d'engendrer un signal de référence à fréquence arbitraire,
- un premier diviseur de fréquence à rapport de division commandé, ledit premier diviseur de fréquence recevant le signal à fréquence arbitraire de référence et délivrant en fonctionnement un signal de sortie de fréquence instantanée,
- une chaîne de commande du premier diviseur de fréquence alimentée par ledit oscillateur de référence.

La présente invention a pour but de remédier aux inconvénients précités par la mise en oeuvre d'un générateur de signaux à fréquence variable programmable selon une loi de variation polynomiale du temps du type de celui mentionné ci-dessus en référence au document EP-A-0 088 669.

Un autre objet de la présente invention est la mise en oeuvre d'un générateur de signaux à fréquence variable programmable pouvant engendrer des valeurs de fréquence très élevées.

Un autre objet de la présente invention est la mise en oeuvre d'un générateur de signaux à fréquence variable programmable permettant d'établir une loi de variation de fréquence continue en fonction du temps, la loi de variation pouvant consister en une pluralité de lois élémentaires de variation sucessives.

Un autre objet de la présente invention est également la mise en oeuvre d'un générateur de signaux à fréquence variable programmable sous forme de circuit intégré, le circuit intégré étant susceptible de constituer un élément périphérique de l'unité centrale d'un ordinateur, d'un calculateur ou d'un microordinateur.

Le dispositif générateur de signaux à fréquence variable programmable selon une loi de variation polynomiale du temps, objet de l'invention, est remarquable en ce que ladite chaîne de commande du premier diviseur de fréquence alimentée par l'oscillateur de référence comporte, connectés en cascade, un deuxième diviseur de fréquence à rapport de division commandé et un premier système intégrateur programmable, dont la sortie délivre au premier diviseur de fréquence la valeur du rapport de division instantané et en ce que ledit dispositif comporte en outre une chaîne de commande du deuxième diviseur de fréquence comportant un deuxième système intégrateur recevant le signal de sortie et délivrant le rapport de division instantané audit deuxième diviseur à rapport de division commandé, ledit premier et deuxième système intégrateur effectuant une intégration en grandeur et en signe opposé de leurs signaux d'entrée, ledit signal de sortie présentant une fréquence instantanée de la forme polynomiale

$$FS = \sum_{j=0}^{n} K_j t^j \,,$$

dans laquelle $t$ représente le temps à partir d'une origine de temps arbitraire et $K_j$ les coefficients de chaque monone de degré $j$.

L'invention trouve application dans tout système mettant en jeu la synthèse de fréquences, l'émission

2

radioélectrique dans les techniques de détection électromagnétique, la commande automatique des moteurs électriques et notamment la robotique, technique dans laquelle l'établissement de lois de commande de moteurs de plus en plus précises et diverses sont nécessaires.

Elle sera mieux comprise à la lecture de la description ci-après et des dessins dans lesquels :

- la figure 1 représente un schéma synoptique d'un dispositif générateur de signaux à fréquence variable programmable selon une loi de variation polynomiale du temps, conformément à la présente invention,
- la figure 2 représente un mode de réalisation avantageux non limitatif du dispositif générateur tel que représenté en figure 1,
- la figure 3a représente un schéma d'un dispositif générateur conforme à l'objet de l'invention, plus spécialement adapté en vue d'une utilisation pour la commande d'un moteur tel qu'un moteur synchrone et les figures 3b, 3c, 3d représentent différentes lois de commande en vitesse d'un moteur obtenues au moyen d'un dispositif générateur tel que représenté en figure 3a,
- la figure 4 représente un schéma d'un dispositif générateur, conforme à l'objet de l'invention plus spécialement adapté en vue d'engendrer des formes d'ondes sinusoïdales,
- la figure 5a représente un schéma d'un dispositif générateur conforme à l'objet de l'invention, plus particulièrement adapté pour la commande de moteurs pas à pas et la figure 5b représente un gabarit de commande en vitesse du moteur pas à pas susceptible d'être mis en oeuvre au moyen du dispositif générateur tel que représenté en figure 5a.

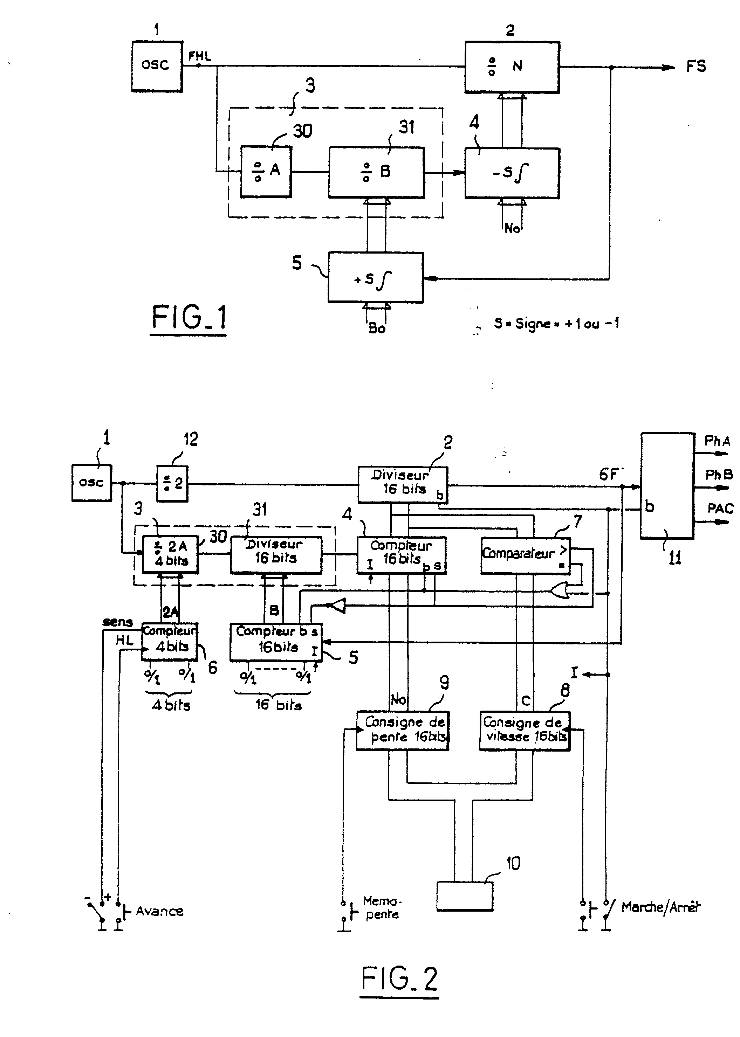

Le dispositif générateur de signaux à fréquence variable programmable selon une loi polynomiale du temps, objet de la présente invention, sera tout d'abord décrit en relation avec la figure 1.

Sur la figure 1 précitée, le dispositif générateur de signaux à fréquence variable programmable permet l'obtention d'une loi de variation de la fréquence FS du signal de sortie selon une loi polynomiale du temps. Par loi polynomiale du temps de la fréquence FS du signal de sortie on entend une loi de fréquence de la forme

$$FS = \sum_{j=0}^{n} K_j t^j,$$

dans laquelle t représente le temps à partir d'une origine de temps arbitraire et $K_j$ les coefficients de chaque monome de degré j, les coefficients $K_j$ étant déterminés en fonction de paramètres d'initialisation du dispositif générateur ainsi qu'il sera décrit ci-après dans la description.

Ainsi qu'il apparaît sur la figure 1 précitée, le dispositif générateur comprend un oscillateur de référence, noté 1, permettant d'engendrer un signal de référence à fréquence arbitraire FHL. Un premier diviseur de fréquence, noté 2, à rapport de division N commandé reçoit le signal à fréquence arbitraire de référence FHL et délivre en fonctionne-ment un signal de sortie de fréquence instantanée FS. Le signal de sortie du premier diviseur 2 constitue le signal de sortie du disPositif générateur objet de l'invention. Une chaîne de commande du premier diviseur de fréquence 2 est alimentée par l'oscillateur de référence 1 et comporte, connectés en cascade, un deuxième diviseur de fréquence 3 à rapport de division commandé et un premier système intégrateur 4 programmable, dont la sortie délivre au premier diviseur de fréquence 2 la valeur du rapport de division instantané N.

Une deuxième chaîne de commande du deuxième diviseur de fréquence 3 comporte un deuxième système intégrateur 5 recevant le signal de sortie de fréquence instantanée FS et délivre le rapport de division instantané au deuxième diviseur 3 à rapport de division commandé. Le premier 4 et deuxième 5 système intégrateur effectuent une intégration en grandeur et en signe opposé, le signe de l'intégration étant noté S avec S = ±1 , de leurs signaux d'entrée. Ainsi, le premier 4 et deuxième 5 système intégrateur présentent à chaque instant une fonction de transfert notée $-S\int$ et $+S\int$ ou réciproquement ainsi que noté en figure 1. Le premier 4 et le deuxième 5 système intégrateur sont susceptibles de permettre à l'origine du paramètre temps t une initialisation des rapports de division N et B des premier et deuxième diviseurs de fréquence 2, 3 aux valeurs No et Bo respectivement.

Conformément à un mode de réalisation avantageux non limitatif du dispositif générateur, objet de l'invention, l'oscillateur de référence 1 peut être constitué par un générateur d'impulsions à fréquence de récurrence fixe piloté par quartz. Les premier 3 et deuxième 5 systèmes intégrateurs peuvent alors être constitués par des dispositifs compteurs-décompteurs d'impulsions.

De la même manière, les premier 2 et deuxième 3 diviseurs de fréquence à rapport de division commandé peuvent être constitués par des circuits à retard programmables et, avantageusement, par des circuits logiques binaires commandés assurant en fonction de leur rapport de division instantané respectif N, B, la division correspondante du nombre d'impulsions de leur signal d'entrée, ainsi qu'il sera explicité plus en détail ultérieurement dans la description.

Selon un mode de réalisation particulièrement avantageux non limitatif, représenté en figure 1, notamment, le deuxième diviseur 3 comporte, connectés en cascade, un premier diviseur de fréquence 30 de rapport de division A ajustable, indépendamment de la deuxième chaîne de commande et un deuxième diviseur de fréquence 31 à rapport de division commandé par la deuxième chaîne de la commande constituée par le deuxième système intégrateur.

Le fonctionnement du dispositif générateur tel que représenté en figure 1 peut être décrit de la manière ci-après.

L'oscillateur 1 de référence engendre des impulsions à la fréquence de récurrence de référence FHL. Le premier diviseur de fréquence 2 délivre le signal de sortie de fréquence instantanée FS = FHL/N relation dans laquelle N est la valeur instantanée du rapport de division du premier diviseur 2. Le deuxième diviseur de fréquence 3, constitué par les deux diviseurs en cascade 30 et 31 délivre à sa sortie un signal de fréquence instantanée

$$Fi = \frac{FHL}{A.B}$$

relation dans laquelle B représente la valeur instantanée du rapport de division du diviseur 31. Le premier système intégrateur 4 permet en fonction de la valeur de S, $S = \pm 1$ d'effectuer une intégration positive ou négative des impulsions à partir d'une valeur initiale No. Le premier système intégrateur 4 constitué par un compteur intégrateur ainsi que décrit précédemment permet d'effectuer un comptage ou un décomptage des impulsions reçues en fonction de la valeur du paramètre de signe S. Le premier système intégrateur 4 délivre la valeur instantanée du rapport de division N au premier diviseur 2.

Le deuxième système intégrateur 5 effectue également en fonction de la valeur du paramètre de signe S une intégration négative ou positive des impulsions à partir d'une valeur initiale Bo. Il effectue donc un décomptage ou un comptage des impulsions constituées par le signal de sortie de fréquence FS et délivre la valeur instantanée du rapport de division B au deuxième diviseur 3, plus particulièrement au diviseur programmable 31. Les différentes fonctions de transfert des éléments constitutifs du dispositif générateur objet de l'invention représenté en figure 1, s'écrivent :

$B = S\int FSdt$ et le signal délivré par le deuxième diviseur 3 et plus particulièrement par le diviseur 31 s'écrit :

$$Fi = \frac{FHL}{AB} = \frac{FHL}{A.S\int FSdt}$$

Le rapport de division N du premier diviseur 2 s'écrit :

$$N = -S\int Fidt = -\int \frac{FHL}{A\int FSdt}\, dt$$

et la fréquence FS du signal de sortie s'écrit

$$FS = \frac{FHL}{N} = \frac{FHL}{-\int \frac{FHL}{A\int FSdt}\, dt}$$

$$FS = \frac{-1}{\int \frac{1}{A\int FSdt}\, dt}$$

Pour une fréquence FS de la forme

$$FS = K_n t^n \qquad \int FSdt = K_n \frac{t^{n+1}}{n+1} \qquad et$$

$$\int \frac{1}{A\int FSdt} = \frac{n+1}{AK_n} \int \frac{1}{t^{n+1}} dt = -\frac{n+1}{nAK_n} \cdot \frac{1}{t^n}$$

$$et \; FS = K_n t^n = \frac{-1}{-\frac{n+1}{nAK_n} \cdot \frac{1}{t^n}} = \frac{nAK_n}{n+1} t^n$$

La valeur du degré n du monome d'ordre n se détermine de façon que

$$\frac{nA}{n+1} = 1$$

et le degré n correspondant vérifie la relation :

$$n = \frac{A}{A-1} \; .$$

Pour A = 1, la fréquence FS du signal de sortie est $FS = Ke^t$, la valeur de K étant fixée par le passage de la courbe représentative de la loi de variation en un point qui peut être le premier point.

Ainsi, de par le principe de superposition des états d'équilibre physique, la fréquence FS du signal de sortie est bien une fréquence instantanée de la forme

$$FS = \sum_{j=0}^{n} K_j t^j$$

en fonction de la valeur des paramètres A, Bo, No du dispositif générateur objet de l'invention.

Le dispositif générateur tel que décrit en figure 1 et en figure 2 notamment, permet en fait d'obtenir une variation de la fréquence FS du signal de sortie selon des valeurs discrètes, la loi de variation étant matérialisée par une succession de points constitués en fait par les impulsions délivrées par le premier diviseur 2, la fréquence instantanée FS du signal de sortie étant définie comme l'inverse du temps qui sépare deux impulsions ou points consécutifs. En fait, le premier diviseur de fréquence 2 est un générateur programmé d'espace entre points : à chaque point ou impulsion délivrée par l'oscillateur de référence 1, il prend en compte la valeur N instantanée du rapport de division et attend N impulsions engendrées par l'oscillateur de référence 1 pour engendrer l'impulsion suivante constitutive du signal de sortie à fréquence FS.

Les points FSi de la courbe ou loi de variation de la fréquence de sortie FS sont définis de la manière ci-après, en fonction de chaque instant ti

$$FSi = \frac{FHL}{Ni-1}$$

où Ni représente la valeur du rapport de division N à l'instant i du premier diviseur 2, et la pente Pi de courbe ou loi de variation à l'instant ti s'écrit :

$$Pi = \frac{FSi+1 - FSi}{Ni/FHL}$$

A l'instant to de démarrage du dispositif générateur objet de l'invention, les premier et deuxième diviseurs sont initialisés aux valeurs No, A, Bo et la valeur de S est fixée. Une étude par itération pour S = 1 et Bo = 1 montre que la valeur du rapport de division Ni à l'instant ti du premier diviseur 2 s'écrit

$$Ni = Ni-1 \left(1 - \frac{1}{i.A}\right) = No \left(1 - \frac{1}{A}\right).\left(1 - \frac{1}{2A}\right)...\left(1 - \frac{1}{i.A}\right)$$

$$\text{soit } Ni = No \times \delta i \text{ avec } \delta i = \prod_{\rho=1}^{i} \left(1 - \frac{1}{\rho.A}\right)$$

L'expression $\delta i$ représente l'atténuation en fréquence pour l'impulsion finale d'ordre i et

$$Fi + 1 = \frac{FHL}{Ni}$$

à l'instant ti + 1.

De même, chaque instant d'ordre i + 1 vérifie la relation :

$$ti + 1 = \frac{1}{FHL} (No + N1 + ... + Ni)$$

$$= \frac{No . \gamma i}{FHL} \text{ avec } \gamma i = 1 + \delta 1 + \delta 2 + .... \delta i$$

$\gamma i$ représentant l'image discrétisée de l'intégrale du temps.

La valeur de K coefficient du monome de degré n peut alors être déterminée par

$$Fi + 1 = K(ti + 1)^n \text{ avec } n = \frac{1}{A - 1}$$

$$Fi + 1 = \frac{FHL}{No\delta i} = K\left[\frac{No}{FHL} \gamma i\right]^n$$

et le coefficient K précité vérifie la relation

$$K = \left(\frac{FHL}{No}\right)^{n + 1} . \frac{1}{\delta i \gamma i^n}$$

L'expression

$$\alpha i = \frac{1}{\delta i \gamma i^n}$$

tend vers une valeur constante $\alpha$ lorsque i tend vers l'infini pour une valeur donnée de A rapport de division du diviseur 30 et de n.

EP 0 251 908 B1

Un exemple de valeurs correspondantes de A, n et $\alpha$ est donné dans le tableau ci-après.

| A | n | $\alpha$ |
|---|---|---|
| 1,5 | 2 | 2,13 |
| 2 | 1 | 1,57 |
| 3 | 1/2 | 1,28 |
| 4 | 1/3 | 1,19 |
| 5 | 1/4 | 1,14 |

$$\text{avec } K = \alpha \left(\frac{FHL}{No}\right)^{n+1}$$

La pente de la courbe ou loi de variation en un point Pi d'ordre i d'instant ti s'écrit

$$Pi = \frac{Fi + 1 - Fi}{Ni/FHL} \quad \text{soit} \quad Pi = \frac{FHL^2}{No^2 \delta i^2 . i . A}$$

Dans le cas d'une loi de variation linéaire de la fréquence en fonction du temps, soit pour $n = 1$ et $A = 2$, la pente est égale à K.
L'expression

$$1/\delta i = \frac{2 \times 4 \times 6 \, .... \, \times 2i}{1 \times 3 \times 5 \times 7 \, ... \, \times (2i-1)}$$

et l'expression

$$\frac{1}{2i\delta i^2} = \frac{2 \times 2 \times 4 \times 4 \, .... \, \times (2i - 2) \times 2i}{1 \times 3 \times 3 \times 5 \, .... \, (2i - 1) \times (2i - 1)}$$

est un produit de Wallis tendant vers $\frac{\pi}{2}$ pour i tendant vers l'infini.
La pente P s'écrit :

$$P = \left(\frac{FHL}{No}\right)^2 \times \frac{\pi}{2}$$

Conformément à une caractéristique avantageuse du dispositif générateur objet de l'invention, le premier diviseur de fréquence 30 peut être constitué par un diviseur de fréquence à rapport de division ajustable, la valeur du rapport de division A étant commandée à partir d'une commande extérieure. Il est ainsi possible de modifier la valeur du rapport de division A en cours de fonctionnement, ce qui a pour effet de modifier, au point considéré, le rayon de courbure de la loi de variation de fréquence selon une loi polynomiale du temps au point considéré.

La modification de la valeur du paramètre A par exemple en un point d'ordre i permet d'obtenir deux valeurs de pentes différentes soit par exemple:

7

$$P_{i-1} = 1 \frac{FHL^2}{No^2 \delta i^2 - 1 \; A1 \times (i-1)} \qquad P_i = \frac{FHL^2}{No^2 \delta i^2 \; A2 \times i}$$

Le rapport

$$\frac{P_{i-1}}{P_i}$$

est peu différent de $\frac{A2}{A1}$, ceci ayant pour conséquence qu'il existe un point anguleux d'autant plus marqué que le rapport A2/A1 est grand.

Conformément à une caractéristique avantageuse du dispositif générateur, objet de l'invention, le point anguleux peut être supprimé. Une première solution peut consister à conserver en chaque point d'ordre i - 1, i un produit A x $\delta i$ sensiblement constant. La constance du produit A x $\delta i$ peut être obtenue par modification temporaire locale de la valeur du rapport de division B du système intégrateur 5.

Conformément à une variante de réalisation avantageuse du dispositif générateur objet de l'invention, la modification de pente en l'absence de point anguleux peut, de manière préférentielle, être obtenue au moyen d'une commande du rapport de division A par un circuit extérieur constitué par exemple par un circuit intégrateur. Sur la figure 2, le circuit intégrateur noté 6 est constitué par un compteur intégrateur.

En outre, lors de l'initialisation du dispositif générateur objet de l'invention, il est possible de fixer la valeur de Bo à une valeur supérieure à 1. Dans ce cas, tout se passe comme si la loi de variation de fréquence en fonction du temps était parcourue à partir d'un point translaté.

Les différentes valeurs prises par N sont les suivantes :

$$No$$
$$N1 = No \left( 1 - \frac{1}{ABo} \right)$$

$$N2 = No \left( 1 - \frac{1}{ABo} \right) \left( 1 - \frac{1}{A(Bo + 1)} \right)$$

$$Ni = No \left( 1 - \frac{1}{ABo} \right) \left( 1 - \frac{1}{A(Bo+1)} \right) \cdots \times \left( 1 - \frac{1}{A(Bo+i)} \right)$$

On peut aussi définir un point fictif N'o tel que

$$No = N'o \left( 1 - \frac{1}{A} \right) \left( 1 - \frac{1}{2A} \right) \cdots \left( 1 - \frac{1}{A(Bo-1)} \right)$$

Dans ce cas, la valeur de K est :

$$K' = \alpha \left( \frac{FHL}{No'} \right)^{n+1} = \alpha \left( \frac{\delta Bo - 1 \; FHL}{No} \right)^{n+1}$$

et

$$K' = \frac{1}{R} \alpha \left( \frac{FHL}{No} \right)^{n+1} \qquad \text{avec } R = \frac{1}{\delta Bo - 1}^{n+1}$$

le tableau donne la valeur du coefficient réducteur R :

| BO \ n | 2 | 1 | 1/2 |
|---|---|---|---|
| 1 | 1 | 1 | 1 |
| 2 | 27 | 4 | 1,84 |
| 3 | 91 | 7,11 | 2,41 |
| 4 | 193 | 10,24 | 2,88 |
| 5 | 334 | 13,375 | 3,28 |
| 6 | 514 | 16,5 | 3,64 |
| 7 | 732 | 19,65 | 3,97 |
| 8 | 988 | 22,8 | 4,27 |

Ce coefficient réducteur est d'autant plus efficace que n est grand.

A partir du premier point, la courbe décrite est telle que la valeur de la fréquence FS est donnée par

$$FS = K' \ (t+to)^n \ \text{avec} \ to = \frac{1}{FHL} \ (N'o + N'1 \ldots + N_{BO-1})$$

L'intérêt du coefficient réducteur est de pouvoir diminuer la valeur de K lorsqu'il n'est plus possible d'augmenter la valeur initiale No du fait de la capacité maximale des compteurs. Pour une valeur No donnée, on a un réseau de courbes qui passent par un point fixe de fréquence

$$FS_{MIN} = \frac{FHL}{NoMAX}$$

Ceci a pour effet d'augmenter le temps de montée à une même fréquence.

Le sens de parcours de la courbe, c'est-à-dire la variation de la fréquence du signal de sortie FS, est déterminé par le signe de S. Le seul fait, à un instant déterminé, d'inverser le signe de S a pour effet d'inverser le sens de parcours et la variation de la fréquence FS du signal de sortie.

Sur le schéma de la figure 2, on a représenté les différents constituants du dispositif objet de l'invention. L'oscillateur 1 peut de manière avantageuse, être constitué par un oscillateur générateur d'impulsions à 2 MHz de la série CEPE OM 16, le premier diviseur 2 par un diviseur 16 bits par exemple et le deuxième diviseur 3 peut être constitué par un premier diviseur ajustable de gain 2A,30,suivi d'un diviseur 16 bits. Le premier et le deuxième compteur intégrateur 4, 5, peuvent de même consister en un compteur 16 bits. Un compteur 4 bits 6 permet d'ajuster le diviseur ajustable 30. Un diviseur auxiliaire 12,diviseur par deux par exemple,permet en liaison avec le diviseur ajustable 30 d'obtenir un rapport des rapports de division correspondants en valeurs non entières.

En outre, ainsi qu'il apparaît en figure 2, le dispositif objet de l'invention peut comprendre également, de manière avantageuse, une boucle de comparaison de la valeur de la fréquence instantanée FS du signal de sortie, comparateur numérique 7,à une valeur de seuil délivrée par un générateur de consigne programmable 8. De même, la valeur initiale No du premier intégrateur 4 est délivrée par un générateur de consigne numérique programmable 9. Les générateurs de consigne 8 et de valeur initiale 9 peuvent être programmés à partir de roues codeuses 10 ou à partir de tout autre moyen. En particulier, un microordinateur peut être utilisé. La boucle de comparaison permet, sur comparaison positive de la valeur de la

EP 0 251 908 B1

fréquence instantanée FS, à la valeur de seuil ou consigne, une réinitialisation du système.

En outre, et ainsi qu'il sera décrit ultérieurement dans la description de façon plus détaillée, la sortie à fréquence FS peut être reliée à un circuit générateur sinusoïdal 11, triphasé par exemple,en vue d'une utilisation pour la commande de moteurs synchrones.

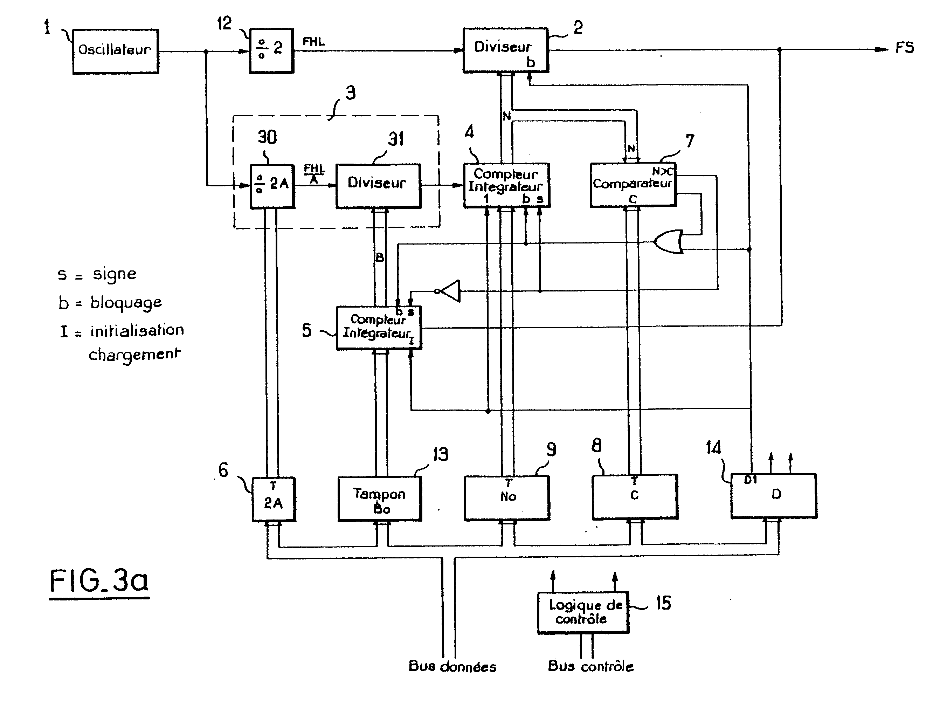

Sur la figure 3a, on a représenté un schéma d'un dispositif générateur conforme à l'objet de l'invention plus spécialement adapté en vue d'une utilisation pour la commande d'un moteur tel qu'un moteur synchrone.

Ainsi qu'on pourra le remarquer, le dispositif générateur comporte dans ce cas, outre les éléments de la figure 2, une série de mémoires tampon 13, 14 interconnectées par une liaison de type BUS, bus de données, à un microordinateur par exemple. De même les générateurs de consigne 9, 8 et le compteur 4 bits 6 peuvent être remplacés par des mémoires tampons interconnectées au BUS de données.

Les diverses valeurs de consigne ou de commande sont alors mémorisées dans les mémoires tampon correspondantes.

La mémoire 6 mémorise la valeur 2A qui permet de choisir la puissance de t ou degré du polynôme.

Cette valeur peut être modifiée en cours de fonctionnement, par exemple pour démarrer avec une accélération croissant linéairement puis fonctionnement à accélération constante.

La mémoire 13 mémorise la valeur initiale Bo, la mémoire 9 la valeur No et la mémoire 8 la fréquence FS ou valeur de consigne à atteindre, laquelle s'analyse en la vitesse à atteindre par le moteur. Cette consigne peut être modifiée à tout instant.

La mémoire 14 mémorise les ordres de commande par tout ou rien, tels que blocage du dispositif par valeur de la sortie D1, les premier 4 et deuxième 5 intégrateurs étant initialisés. Pour la valeur complémentée de D1, $\overline{D1}$ le dispositif est débloqué et la fréquence de sortie FS évolue vers la fréquence et la valeur finale est déterminée par la valeur de consigne C.

Le circuit 15 permet l'adressage des diverses mémoires.

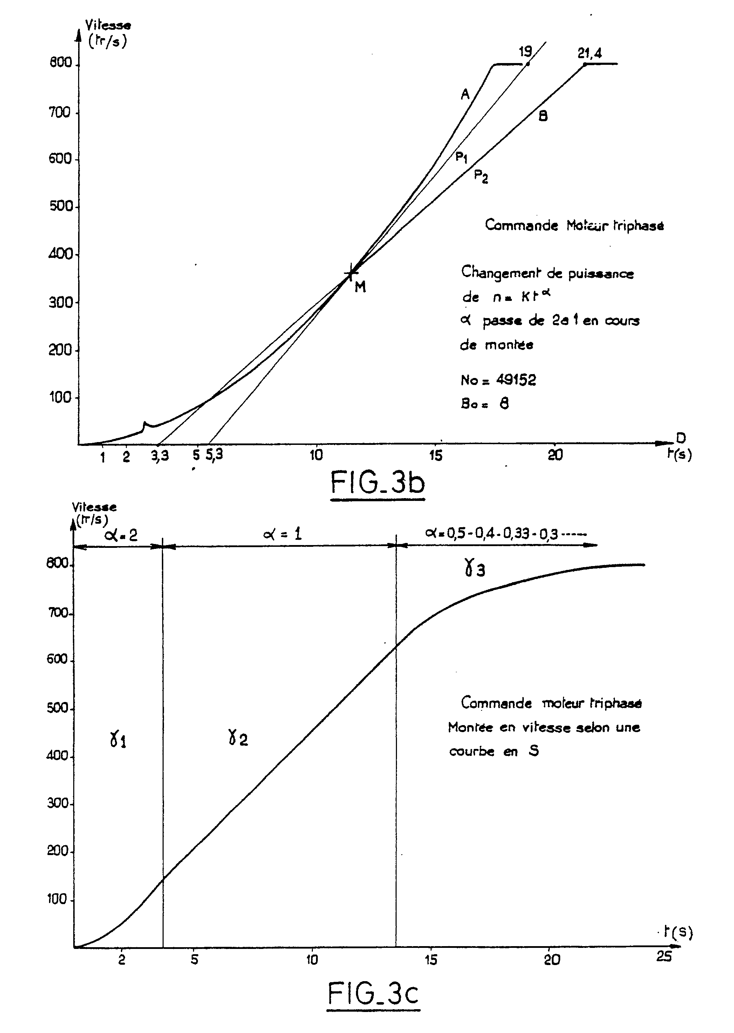

Sur la figure 3b on a représenté une loi de commande en vitesse d'un moteur synchrone. La courbe A est tracée avec $\alpha = 1$ jusqu'à la fin du tracé, la courbe B est tracée avec $\alpha = 2$ jusqu'au point M, elle est superposée à la courbe A. Au point M, on passe de $\alpha = 2$ à $\alpha = 1$ avec rupture de pente.

Sur la figure 3c, on a représenté une commande de moteur synchrone avec montée en vitesse selon une courbe en S. La partie de courbe notée $\gamma 1$, pour $\alpha = 2$, correspond à une accélération linéaire du type $\gamma = \gamma ot$. La partie de courbe notée $\gamma 2$ correspond à une accélération constante $\gamma 2 =$ constante pour $\alpha = 1$. La partie de courbe notée $\gamma 3$ correspond pour $\alpha = 0,5, 04 \ldots$ à une décélération programmée.

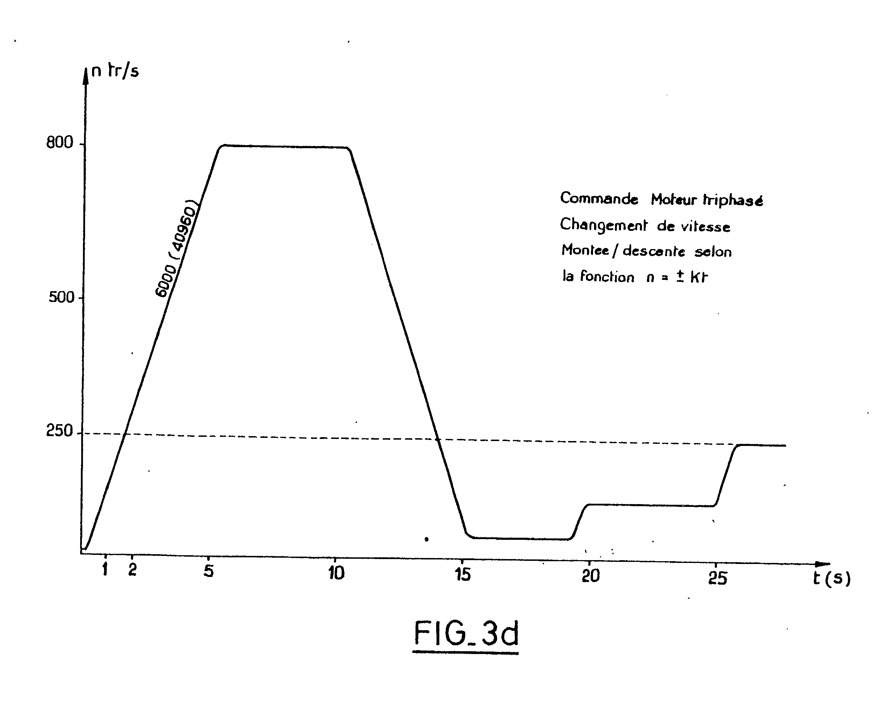

Sur la figure 3d, on a enfin représenté la loi de variation de vitesse d'un moteur synchrone commandé en montée/descente selon une fonction du type $n = \pm Kt$.

Sur les figures 3b, 3c, 3d, l'axe des abscisses est gradué en unité de temps,en secondes,et l'axe des ordonnées en nombre de tours par seconde.

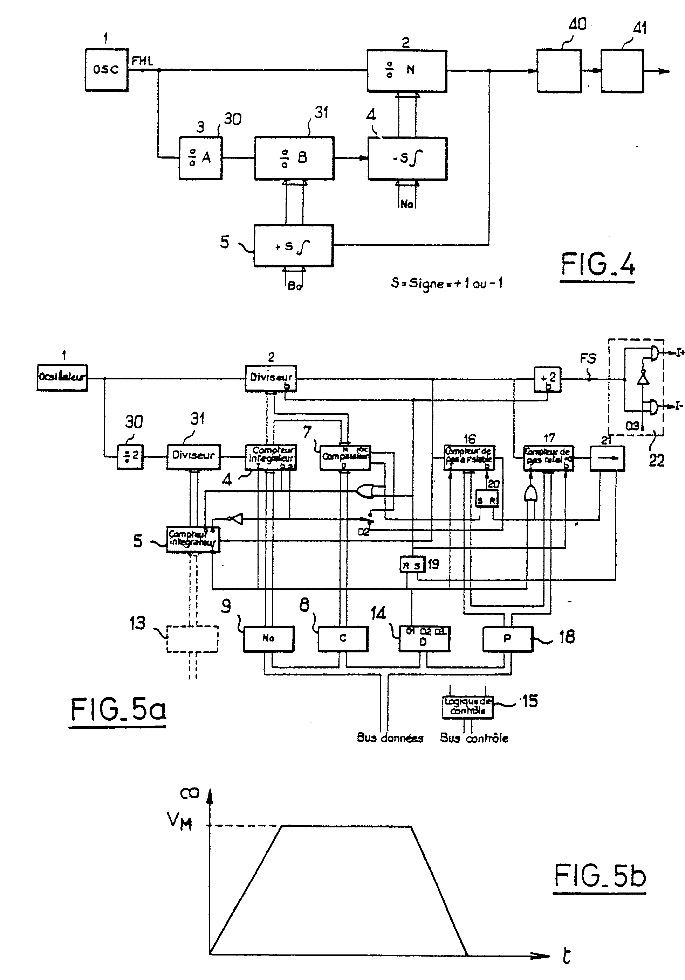

Une autre variante de réalisation du dispositif générateur, objet de l'invention, sera décrite en liaison avec la figure 4.

Sur cette figure, on remarquera que la partie générateur du dispositif est identique au schéma de la figure 1. En outre, en vue d'engendrer une forme d'onde sinusoïdale à fréquence variable selon une loi de variation polynomiale du temps, le dispositif comprend en outre, connecté en sortie du premier diviseur de fréquence 2 à rapport de division commandé, un circuit de type bistable 40 permettant d'engendrer à partir du signal de sortie à fréquence FS un signal rectangulaire par exemple de même fréquence instantanée. En outre, un filtre de fréquence harmonique 41 est asservi à la fréquence fondamentale du signal rectangulaire et permet de délivrer un signal dont la fréquence correspond au premier harmonique du signal rectangulaire.

Dans l'utilisation précitée, le dispositif générateur, objet de l'invention, peut avantageusement trouver application aux circuits générateurs de fréquences pour radars à agilité de fréquence, aux systèmes d'émission à émission codée.

Dans ce cas bien entendu, en fonction de la bande d'émission choisie, les circuits terminaux peuvent être réalisés en technologie TTLS ou ECL par exemple.

Un autre mode de réalisation avantageux d'un dispositif générateur conforme à l'invention sera décrit en liaison avec les figures 5a et 5b dans le cas de la commande des moteurs pas à pas.

Dans cette utilisation, un gabarit de commande en vitesse est utilisé, gabarit tel que représenté en figure 5b par exemple.

Sur la figure 5a, le dispositif générateur conforme à la présente invention comporte sensiblement les mêmes éléments que le dispositif générateur représenté en figure 3a par exemple en ce qui concerne les éléments 13, 11, 9, 8, 14 et 15.

En outre, la consigne du nombre de pas est mémorisée dans la mémoire tampon 18 et un compteur de

10

pas total 17 est initialisé au démarrage avec ce nombre de pas, comme la mémoire tampon 18. Le sens de rotation du moteur est commandé par une commande tout ou rien D3 délivrée par la mémoire 14, la commande agissant directement au niveau d'un circuit de commutation 50 délivrant un signal correspondant I$^+$, I$^-$. La sortie à fréquence FS est divisée par deux. Un compteur de pas à fréquence stable 16 est en outre prévu . Grâce aux deux compteurs 16 et 17 et au tampon 18 qui mémorise la consigne P, le gabarit est décrit correctement. A l'initialisation, les compteurs 16 et 17 sont chargés avec la valeur P. La variable discrète D1 mémorisée en 14 arme la bascule 19 qui débloque le système. La fréquence FS de sortie croît selon la pente programmée No, les compteurs 16, 17 décomptent de leur valeur initiale les impulsions vues en FS. Lorsque la vitesse maximale est atteinte, le comparateur 7 indique l'égalité et arme la bascule 20 qui bloque le compteur 16. Le compteur 17 continue à décompter les impulsions jusqu'à ce qu'il passe à zéro, ce point correspondant à un point de symétrie du gabarit. Le compteur 17 est alors rechargé avec la consigne P, la bascule 20 est désarmée, le compteur 16 est débloqué, son contenu représentant le nombre d'impulsions restant à fréquence constante. Lorsque le contenu du compteur 16 passe à zéro, le signe de S est inversé et la fréquence se met à décroître selon la pente programmée. Lorsque le compteur 17 passe de nouveau à zéro, la bascule 19 est désarmée et le système est bloqué jusqu'à une nouvelle commande. La variable discrète D2 permet de se placer en commande vitesse.

On a ainsi décrit un dispositif générateur de signaux à fréquence variable à haute performance dont la diversité d'applications montre tout l'intérêt. Le mode de réalisation décrit du dispositif selon l'invention en logique câblée n'est en aucun cas limitatif. Bien au contraire, le dispositif générateur peut de manière très avantageuse être réalisé sous forme de circuit intégré, tout au moins en ce qui concerne la partie générateur proprement dite.

Dans ce cas, le circuit intégré peut avantageusement être agencé de façon qu'il constitue un circuit périphérique de microprocesseur ou de l'unité centrale d'un microordinateur.

## Revendications

1.  Dispositif générateur de signaux à fréquence variable programmable selon une loi de variation polynomiale du temps, comprenant :
    - un oscillateur de référence (1) permettant d'engendrer un signal de référence à fréquence arbitraire (FHL),
    - un premier diviseur de fréquence (2) à rapport de division (N) commandé, ledit premier diviseur de fréquence (1) recevant le signal à fréquence arbitraire de référence (FHL) et délivrant en fonctionnement un signal de sortie de fréquence instantanée (FS),
    - une chaîne de commande du premier diviseur de fréquence alimentée par ledit oscillateur de référence (1), caractérisé en ce que ladite chaîne de commande du premier diviseur de fréquence comporte, connectés en cascade, un deuxième diviseur de fréquence (3) à rapport de division commandé et un premier système intégrateur (4) programmable dont la sortie délivre audit premier diviseur de fréquence (2) la valeur du rapport de division instantanée N, et en ce que ledit dispositif comporte en outre
    - une chaîne de commande dudit deuxième diviseur de fréquence (3) comportant un deuxième système intégrateur (5) recevant ledit signal de sortie (FS) et délivrant ledit rapport de division instantané audit deuxième diviseur (3) à rapport de division commandé, ledit premier (4) et deuxième (5) système intégrateur effectuant une intégration en grandeur et en signe (S) opposé de leurs signaux d'entrée, ledit signal de sortie (FS) présentant une fréquence instantanée de la forme polynomiale

$$FS = \sum_{j=0}^{n} Kj\, t^{j} \ ,$$

    dans laquelle t représente le temps à partir d'une origine de temps arbitraire et Kj les coefficients de chaque monome de degré j.

2.  Dispositif selon la revendication 1, caractérisé en ce que l'oscillateur de référence (1) est un générateur d'impulsions à fréquence de récurrence fixe piloté par quartz.

3.  Dispositif selon l'une des revendications 1 ou 2, caractérisé en ce que lesdits premier et deuxième systèmes intégrateurs sont constitués par des dispositifs compteurs-décompteurs d'impulsions.

4. Dispositif selon l'une des revendications 1 à 3 précédentes, caractérisé en ce que lesdits diviseurs de fréquence (2),(3), à rapport de division commandé sont constitués par des circuits à retard programmable.

5. Dispositif selon l'une des revendications 1 à 3 précédentes, caractérisé en ce que lesdits diviseurs de fréquence (2),(3),à rapport de division commandé sont constitués par des circuits logiques binaires commandés.

6. Dispositif selon l'une des revendications 2 ou 3, caractérisé en ce que ledit deuxième diviseur (3) comporte, connectés en cascade, un premier diviseur de fréquence (30) de rapport de division ajustable (A) déterminé et un deuxième diviseur de fréquence (31) à rapport de division (B) commandé.

7. Dispositif selon l'une des revendications 2 à 6, caractérisé en ce que la fréquence instantanée (FS) du signal de sortie est définie comme l'inverse du temps séparant deux impulsions délivrées par le premier diviseur de fréquence (2).

8. Dispositif selon les revendications 6 et 7, caractérisé en ce que ledit premier diviseur de fréquence (30) à rapport de division ajustable(A) est un diviseur programmable commandé par un circuit intégrateur à partir d'une valeur de référence, la commande de la valeur du rapport de division A permettant d'effectuer une modification continue de la loi de variation polynomiale de la fréquence en fonction du temps.

9. Dispositif selon l'une des revendications 1 à 8, caractérisé en ce que lesdits premier et deuxième systèmes intégrateurs (4) et (5) effectuant une intégration en grandeur et en signe (S) de leurs signaux d'entrée permettent, en fonction du choix dudit signe (S) une excursion de la loi de variation polynomiale de la fréquence de sortie (FS) par valeurs croissantes respectivement décroissantes de la fréquence en fonction du temps.

10. Dispositif selon l'une des revendications 1 à 9, caractérisé en ce qu'il comprend en outre une boucle de comparaison de la valeur de la fréquence instantanée (FS) du signal de sortie à une valeur de seuil programmable, ladite bande de comparaison permettant sur comparaison positive de ladite valeur de la fréquence instantanée (FS) à ladite valeur de seuil une réinitialisation du système.

11. Dispositif selon l'une des revendications 1 à 10, caractérisé en ce que en vue d'engendrer une forme d'onde sinusoïdale à fréquence variable selon une loi de variation polynomiale du temps, ledit dispositif comprend,en outre,connectés en sortie du premier diviseur de fréquence (2) à rapport de division commandé, un circuit de type bistable permettant d'engendrer à partir du signal dit de sortie à fréquence (FS) un signal rectangulaire de même fréquence instantanée, un filtre de fréquence harmonique asservi à la fréquence fondamentale dudit signal rectangulaire.

12. Dispositif selon l'une des revendications précédentes, caractérisé en ce qu'il est réalisé sous forme de circuit intégré.

13. Utilisation d'un dispositif générateur de signaux à fréquence variable selon l'une des revendications 1 à 12 précédentes, pour la commande de moteurs, caractérisée en ce que les paramètres de commande sont mémorisés dans des mémoires auxiliaires interconnectées par une liaison de type BUS à un terminal d'ordinateur ou à un micro-ordinateur.

14. Utilisation selon la revendication 13, caractérisée en ce que, en vue de la commande de moteurs pas à pas, un gabarit de commande en vitesse du moteur est utilisé, ledit gabarit mettant en jeu le comptage de pas totalement effectués, le comptage de pas à fréquence maximum, la commande en montée et en descente en vitesse du moteur étant effectuée par le changement du signe des systèmes intégrateurs (4),(5).

**Claims**

EP 0 251 908 B1

1. A signal generator with variable frequency programmable according to a time-polynomial variation law, comprising:-

a reference oscillator (1) for generating a reference signal at an arbitrary frequency (FHL),

a first frequency divider (2) with a controlled division ratio (N), said first frequency divider (2) receiving said arbitrary frequency reference signal (FHL) and delivering in use an instantaneous frequency output signal (FS),

a control chain for said first frequency divider fed by said reference oscillator (1), characterized in that said control chain for said first frequency divider comprises, connected in cascade, a second frequency divider (3) with a controlled division ratio and a first programable integrator system (4) of which the output delivers to said first frequency divider (2) the value of said instantaneous division ratio (N),

a control chain for said second frequency divider (3) comprising a second integrator system (5) receiving said output signal (FS) and delivering said instantaneous division ratio to said second divider (3) with a controlled division ratio, said first (4) and second (5) integrator systems carrying out a magnitude integration at a sign (S) opposite to their input signals, said output signal (FS) having an instantaneous frequency of the polynomial form

$$FS = \sum_{j=0}^{n} K_j t^j$$

in which t represents the time from an arbitrary time origin and $K_j$ the coefficients of each monomial of degree j.

2. A device according to claim 1, wherein said reference oscillator controlled, fixed recurrence frequency.

3. A device according to any one of claims 1 to 2, wherein said first and second integrator systems are constituted by up and down pulse counters.

4. A device according to any one of claims 1 to 3, wherein said frequency dividers constituted by programmable delay circuits.

5. A device according to any one of claims 1 to 3, wherein said frequency dividers (2),(3) with controlled division ratios are constituted by controlled binary logic circuits.

6. A device according to any one of claims 2 or 3, wherein said second divider (3) comprises, connected in cascade, a first frequency divider (30) with a determined adjustable division ratio (A) and a second frequency divider (31) with a controlled division ratio (B).

7. A device according to any one of claims 2 to 6, wherein said instantaneous frequency (FS) of said output signal is defined as the reciprocal of the time separating two pulses delivered by said first frequency divider (2).

8. A device according to any one of claims 6 and 7, wherein said first frequency divider (30) with an adjustable division ratio (A) is a programmable divider controlled by an integrator circuit from a reference value, said control of the value of said division ratio A permitting continuous modification of the polynomial variation law for said frequency as a function of time.

9. A device according to any one of claims 1 to 8, wherein said first (4) and second (5) integrator systems carry out magnitude integration at the sign (S) of their input signals permitting, as a function of the choice of said sign (S), a change of said polynomial variation law for said output frequency (FS) by values respectively increasing and decreasing said frequency as a function of time.

10. A device according to any one of claims 1 to 9, further comprising a comparison loop for said value of said instantaneous frequency (FS) of said output signal with a programmable threshold value, said comparison loop permitting on positive comparison of said value of instantaneous frequency (FS) with said threshold value a resetting of said system.

13

11. A device according to any one of claims 1 to 10, wherein in order to generate a sinusoidal wave form at variable frequency according to a time-polynomial variation law, said device further comprises, connected to an output of said first frequency divider (2) with a controlled division ratio, a bistable circuit permitting generation from said output signal at frequency (FS) a rectangular signal of the same instantaneous frequency, a harmonic frequency filter tuned to a fundamental frequency of said rectangular signal.

12. A device according to any one of the claims mentioned above, wherein it is provided in the form of an integrated circuit.

13. Use of a variable frequency signal generator according to any one of claims 1 to 12, for control of motors, wherein control parameters are memorised in auxiliary memories interconnected by a BUS type connection to either of a computer terminal or a micro-computer.

14. Use according to claim 13, wherein in order to control a stepper motor, a speed control curve for the motor is used, said curve employing counting of the total number of steps made, counting of the maximum frequency of steps, control in rising and fall of speed of said motor being carried out by changing the sign of said integrator systems (4), (5).

## Patentansprüche

1. Generator für die Erzeugung von variablen, programmierbaren Frequenzsignalen gemäß einem Polynom-Änderungsgesetz der Zeit mit:

   - einem Bezugsoszillator (1), der das Erzeugen eines Bezugssignales (FHL) mit beliebiger Frequenz erlaubt,
   - einem ersten Frequenzteiler (2) für gesteuerte Division (N), wobei der erste Frequenzteiler (2) das Bezugssignal (FHL) mit beliebiger Frequenz empfängt und im Betrieb ein Ausgangssignal (FS) mit Momentanfrequenz abgibt,
   - eine vom Bezugsoszillator (1) versorgte Steuerkette des ersten Frequenzteilers,

   dadurch gekennzeichnet, daß die Steuerkette des ersten Frequenzteilers in Kaskadenschaltung einen zweiten Frequenzteiler (3) für gesteuerte Division und eine erste programmierbare Integriereinheit (4) aufweist, deren Ausgang an den ersten Frequenzteiler (2) den momentanen Wert für Division N liefert, und daß der Generator außerdem aufweist:

   - eine Steuerkette des zweiten Frequenzteilers (3) mit einer zweiten Integriereinheit (5), die das Ausgangssignal (FS) empfängt und den momentanen Divisionswert an den zweiten Frequenzteiler (3) für gesteuerte Division abgibt, wobei die erste (4) und die zweite (5) Integriereinheit eine Integration in Größe und Vorzeichen (S) entgegengesetzt zu ihren Eingangssignalen bewirken und das Ausgangssignal (FS) eine Momentanfrequenz der Polynomform

$$FS = \sum_{j=0}^{n} Kjt^j$$

   darstellt, in welcher t die Zeit ab einem beliebigen Zeitursprung und Kj die Koeffizienten jedes Monoms des Grades j bedeuten.

2. Generator nach Anspruch 1, dadurch gekennzeichnet, daß der Bezugsoszillator (1) ein quarzgesteuerter Impulsgenerator für Impulse fester Wiederholfrequenz ist.

3. Generator nach Anspruch 1 oder 2, dadurch gekennzeichnet, daß die erste und die zweite Integriereinheit aus Impuls-Zählern/Abwärtszählern bestehen.

4. Generator nach einem der Ansprüche 1 bis 3, dadurch gekennzeichnet, daß die Frequenzteiler (2, 3) für gesteuerte Division aus programmierbaren Verzögerungsschaltungen bestehen.

**5.** Generator nach einem der Ansprüche 1 bis 3, dadurch gekennzeichnet, daß die Frequenzteiler (2, 3) für gesteuerte Division aus gesteuerten binären Logikschaltungen bestehen.

**6.** Generator nach Anspruch 2 oder 3, dadurch gekennzeichnet, daß der zweite Frequenzteiler (3) in Kaskadenschaltung einen ersten Frequenzteiler (30) für einstellbare (A) bestimmte Division und einen zweiten Frequenzteiler (31) für gesteuerte Division (B) aufweist.

**7.** Generator nach einem der Ansprüche 2 bis 6, dadurch gekennzeichnet, daß die momentane Frequenz (FS) des Ausgangssignales als Inverse der Zeit festgelegt ist, welche zwei Impulse trennt, die durch den ersten Frequenzteiler (2) geliefert sind.

**8.** Generator nach den Ansprüchen 6 und 7, dadurch gekennzeichnet, daß der erste Frequenzteiler (30) für einstellbare Division (A) ein programmierbarer Teiler ist, der durch eine Integrierschaltung ausgehend von einem Bezugswert steuerbar ist, wobei die Steuerung des Wertes für die Division A das Durchführen einer kontinuierlichen Änderung des Polynom-Änderungsgesetzes der Frequenz abhängig von der Zeit erlaubt.

**9.** Generator nach einem der Ansprüche 1 bis 8, dadurch gekennzeichnet, daß die ersten und zweiten Integriereinheiten (4, 5), die eine Integration in Größe und Vorzeichen (S) von ihren Eingangssignalen durchführen, abhängig von der Wahl des Vorzeichens (S) eine Abweichung des Polynom-Änderungsgesetzes der Ausgangsfrequenz (FS) um Werte erlauben, die zeitabhängig mit der Frequenz zunehmen bzw. abnehmen.

**10.** Generator nach einem der Ansprüche 1 bis 9, dadurch gekennzeichnet, daß er außerdem eine Vergleichsschleife für den Wert der Momentanfrequenz (FS) des Ausgangssignales mit einem programmierbaren Schwellenwert aufweist, wobei das Vergleichsband durch positiven Vergleich des Wertes der Momentanfrequenz (FS) mit dem Schwellenwert eine erneute Auslösung des Systems erlaubt.

**11.** Generator nach einem der Ansprüche 1 bis 10, dadurch gekennzeichnet, daß im Hinblick auf das Erzeugen einer Sinus-Wellenform mit einer Frequenz, die gemäß einem Polynom-Änderungsgesetz der Zeit variabel ist, der Generator außerdem am Ausgang des ersten Frequenzteilers (2) für gesteuerte Division eine bistabile Schaltung, die aus dem genannten Ausgangssignal der Frequenz (FS) ein Rechtecksignal der gleichen Momentanfrequenz zu erzeugen vermag, und ein Filter harmonischer Frequenz, das auf die Grundfrequenz des Rechtecksignales eingestellt ist, aufweist.

**12.** Generator nach einem der vorangehenden Ansprüche, dadurch gekennzeichnet, daß er in der Form einer integrierten Schaltung realisiert ist.

**13.** Verwendung eines Generators für variable programmierbare Frequenzsignale nach einem der Ansprüche 1 bis 12 für die Steuerung von Motoren, dadurch gekennzeichnet, daß die Steuerparameter in Hilfsspeichern abgespeichert sind, die über eine Bus-Verbindung mit einem Rechneranschluß oder einem Mikrorechner verbunden sind.

**14.** Verwendung nach Anspruch 13, dadurch gekennzeichnet, daß im Hinblick auf die Steuerung von Schrittmotoren eine Steuerlehre für die Motordrehzahl verwendet wird, wobei die Lehre das Zählen aller bewirkten Schritte, das Zählen der Schritte mit maximaler Frequenz in Betrieb nimmt und der Befehl für Anwachsen und Abnehmen der Motor-Drehzahl durch Änderung des Vorzeichens der Integriereinheiten (4, 5) bewirkt wird.

FIG_1

S = Signe = +1 ou −1

FIG_2

FIG.3a

s = signe
b = bloquage
I = initialisation
chargement

FIG_3b

FIG_3c

Commande Moteur triphasé
Changement de vitesse
Montee / descente selon
la fonction $n = \pm Kt$

FIG_3d

EP 0 251 908 B1

FIG.4

S = Signe = +1 ou -1

FIG.5a

Bus données    Bus contrôle

FIG.5b